**Europäisches Patentamt**

**European Patent Office**

**Office européen des brevets**

(19)

(11) Numéro de publication : **0 136 955
B1**

(12)

# FASCICULE DE BREVET EUROPÉEN

(45) Date de publication du fascicule du brevet :
02.12.87

(51) Int. Cl.⁴ : **G 01 R 33/022**, G 01 R 33/032

(21) Numéro de dépôt : 84401965.3

(22) Date de dépôt : 02.10.84

(54) Dispositif pour mesurer le gradient d'un champ magnétique par effet magnéto-optique.

(30) Priorité : 04.10.83 FR 8315791

(43) Date de publication de la demande :
10.04.85 Bulletin 85/15

(45) Mention de la délivrance du brevet :
02.12.87 Bulletin 87/49

(84) Etats contractants désignés :
DE GB IT

(56) Documents cités :
EP-A- 0 030 876
THE REVIEW OF SCIENTIFIC INSTRUMENTS, vol. 32,
no. 4, avril 1961, pages 444-448, New York, USA; R.M.
MORRIS et al.: "Design of a second harmonic flux
gate magnetic field gradiometer"

(73) Titulaire : **THOMSON-CSF**
**173, Boulevard Haussmann**
**F-75379 Paris Cédex 08 (FR)**

(72) Inventeur : **Duthoit, François**
**THOMSON-CSF SCPI 173, bld Haussmann**
**F-75379 Paris Cedex 08 (FR)**
Inventeur : **Desormiere, Bernard**
**THOMSON-CSF SCPI 173, bld Haussmann**
**F-75379 Paris Cedex 08 (FR)**

(74) Mandataire : **Desperrier, Jean-Louis et al**
**THOMSON-CSF SCPI 19, avenue de Messine**
**F-75008 Paris (FR)**

## Description

La présente invention concerne un dispositif pour mesurer le gradient d'un champ magnétique en utilisant l'action d'un milieu magnéto-optique sur un faisceau lumineux polarisé, connue sous le nom d'effet Faraday.

Un tel dispositif, que nous appelerons un gradientmètre de champ magnétique, mesure la variation dans l'espace du module du champ magnétique, ou de l'une de ses composantes dans une direction déterminée. Si $h_1$ et $h_2$ sont les valeurs des composantes du champ mesurées à une distance d dans cette direction, la composante du gradient est donnée par l'approximation linéaire :

$$h_2 - h_1/d$$

valable pour une variation spatiale du champ lente devant la distance d.

Selon l'art connu, les gradientmètres sont réalisés par association de deux magnétomètres dont on soustrait les deux signaux de sortie.

La limite pratique de la mesure d'un gradient magnétique est alors imposée par la précision de l'alignement des axes de ces deux capteurs, et par la précision de la mesure de chaque capteur, la distance d étant donnée. Par exemple, si l'on désire mesurer une variation de 1 nT de la composante est-ouest d'une anomalie magnétique naturelle faible devant le champ terrestre ($5 \cdot 10^4$ nT en Europe), le parallélisme de la mesure devra être réalisé à mieux que 4 secondes d'arc.

On sait réaliser des gradientmètres très performants et peu encombrants, du moins pour la partie sensible, en utilisant des SQUID (abréviation anglo-saxonne de Superconducting Quantum Interference Device). Ils ont l'inconvénient de devoir être maintenus à très basse température, 4 °K environ, et le dispositif de réfrigération associé est prohibitif du point de vue encombrement et consommation.

Des gradientmètres à faible consommation et encombrement acceptable ont été réalisés en utilisant deux magnétomètres de type à noyau saturable dits « fluxate », montés en différentiel, comme décrit par exemple dans le document « The review of scientific instruments » volume 32, numéro 4, avril 1961 pages 444-448, New-York, U.S.A. Si la mesure locale du champ est suffisamment précise pour mesurer des gradients faibles, 1 nT/m par exemple, ces gradientmètres présentent l'inconvénient d'avoir un positionnement respectif des deux noyaux magnétiques trop imprécis, conduisant à une mesure du gradient entachée d'erreur, en particulier à cause du défaut de parallélisme indiqué précédemment. La solution généralement adoptée consiste à réaliser un montage le plus stable possible et à corriger, par calibration ou par mise en place de masses magnétiques, ce défaut d'alignement, ce qui est une source de complexité et de manque de fidélité des mesures.

Par ailleurs, il est connu par exemple de la demande de brevet européen n° 0030876 de mesurer un champ magnétique au moyen d'un magnétomètre dit « optique » utilisant l'effet Faraday. Pour cela un faisceau de lumière polarisée traverse un milieu magnéto-optique qui fait tourner le plan de polarisation d'une valeur proportionnelle à la valeur du champ magnétique suivant la direction de propagation. Suivant cette direction on superpose un champ magnétique alternatif de manière à obtenir après détection, filtrage et contre-réaction, une mesure automatique de la valeur algébrique de la composante du champ dans cette direction.

En effet une couche de matériau ferrimagnétique traversée par un faisceau de lumière polarisée fait tourner le plan de polarisation d'un angle θ, appelé rotation de Faraday, donné par la relation :

$$\theta = \theta_0 L(h/Hs) \qquad (1)$$

dans laquelle $\theta_0$ est un coefficient de rotation spécifique, h est la composante du champ magnétique local parallèle à la direction de propagation de la lumière, Hs est le champ dans le plan de la couche perpendiculaire à la direction de propagation, dit champ de saturation, et L est la longueur de la couche dans la direction de propagation.

Pour obtenir la mesure du champ h, on superpose au champ à mesurer un champ sinusoïdal $h(t) = h_0 \sin \omega t$ dans la direction de propagation. En détectant la lumière transmise à travers un analyseur croisé avec la polarisation incidente, on obtient un signal électrique dont le fondamental est proportionnel à h.

L'effet magnéto-optique décrit par la relation (1) suppose que la couche magnéto-optique est relativement épaisse, plusieurs dizaines de microns, de façon à rester dans l'approximation de l'optique géométrique.

Le gradientmètre selon l'invention est défini par la revendication 1.

La direction de mesure est donc matérialisée par la direction du faisceau lumineux, ce qui supprime une cause de défaut de parallélisme. La différence entre les champs locaux est réalisée optiquement.

L'épitaxie sur un substrat unique permet d'obtenir une qualité d'alignement des deux milieux qui est celle du plan de référence du substrat (en général une demi-longueur d'onde). On sait par ailleurs que pour un milieu unique formé d'une couche de 5 mm de long dans la direction du faisceau lumineux on peut mesurer un champ de 0,01 nT.

La précision de mesure de chaque champ local et la dimension réduite de chaque milieu magnéto-optique permet donc d'obtenir un gradientmètre sensible et peu encombrant par rapprochement des deux milieux sensibles. De plus, les défauts habituels des gradientmètres, à savoir la non identité entre les deux milieux et le défaut d'alignement, sont réduits à des valeurs minimes.

D'autres particularités et avantages de l'invention apparaîtront clairement dans la description suivante faite en regard des figures annexées qui représentent :

— les figures 1 et 2, des vues schématiques de dessus et de côté d'un gradientmètre selon l'invention ;

— la figure 3, une vue en perspective d'une réalisation préférée de l'invention ;

— la figure 4, un schéma du système de détection électrique du gradientmètre de la figure 3 ;

— la figure 5, un exemple de réalisation des milieux sensibles du gradientmètre de la figure 3 ;

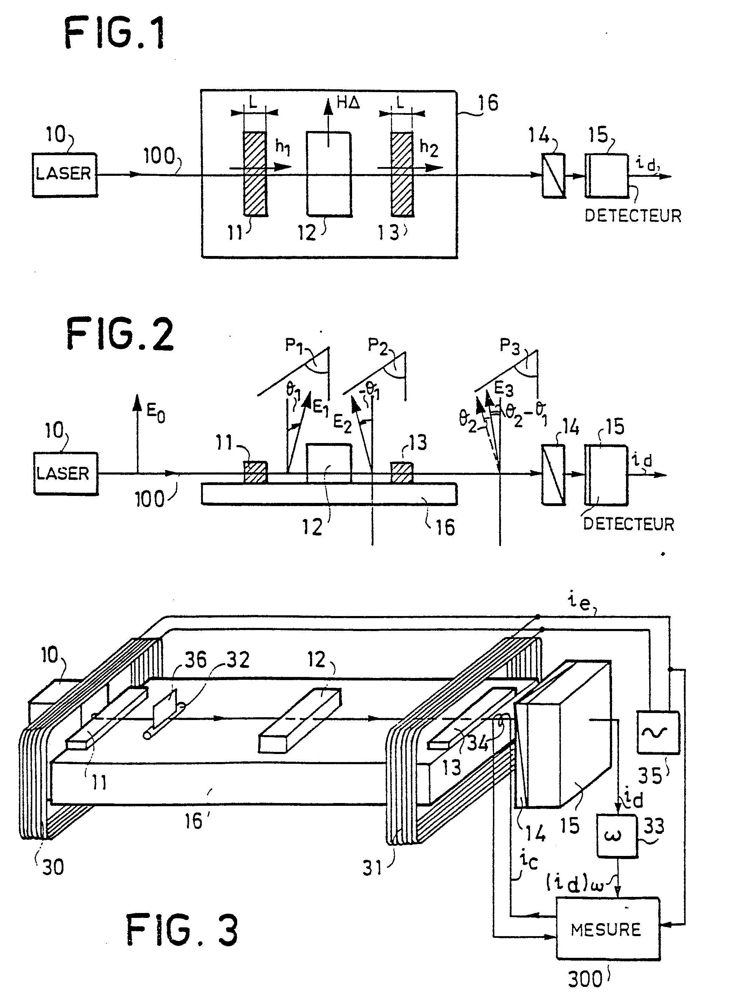

Sur les figures 1 et 2, les capteurs 11 et 13 portés par le substrat 16 sont des couches épaisses (relativement à la longueur d'onde utilisée) de matériau ferrimagnétique.

Un laser 10 émet un faisceau lumineux 100 polarisé rectilignement selon une direction $E_0$ (par convention celle du champ électrique de l'onde électromagnétique).

Ce faisceau traverse successivement la première couche magnéto-optique 11, une lame 1/2 onde 12 dont l'un des deux axes neutres est parallèle à la polarisation initiale du faisceau, la deuxième couche magnéto-optique 13 identique à la première et un analyseur 14 croisé avec la polarisation incidente. Il arrive ensuite sur un photodétecteur 15 qui fournit un signal de sortie $i_d$.

Les deux couches ont une même largeur L et sont solidaires d'un même support plan 16. Elles ont été déposées à la surface de ce support. Un champ permanent $H_s$ de saturation est dans le plan des couches et perpendiculaire à la direction de propagation ; il peut être par exemple créé par des aimants permanents convenablement situés, ou obtenu en plaçant la couche magnéto-optique sous contrainte mécanique.

La lumière émise par un laser est en général polarisée naturellement et il suffit alors d'orienter celui-ci dans le bon sens. Dans le cas contraire on utilisera un polarisateur adéquat entre le laser et la première couche.

Le faisceau lumineux 100 subit une première rotation de Faraday $\theta_1$ en traversant la première couche 11 de largeur L, en raison du champ local $h_1$ existant suivant la direction de propagation ; la valeur de cette rotation est $\theta_1 = Kh_1$ où K est une constante de valeur $\theta_0 L/Hs$.

Le faisceau traverse ensuite la lame 1/2 onde 12 dont l'un des deux axes neutres est placé parallèlement à $E_0$. Sous l'influence de cette lame la polarisation $E_2$ du faisceau en sortie de cette lame est symétrique de la polarisation $E_1$ en entrée par rapport aux lignes neutres de la lame : elle fait donc un angle $-\theta_1$ avec la direction de $E_0$.

Ensuite le faisceau lumineux subit une deuxième rotation de Faraday $\theta_2$ en traversant la deuxième couche 13, de largeur L, proportionnelle au champ local $h_2$ existant suivant la direction de propagation ; sa valeur est $\theta_2 = Kh_2$. La polarisation finale obtenue $E_3$ fait un angle $-\theta_1 + \theta_2$ avec la direction de $E_0$. On a ainsi effectué une soustraction optique des effets des deux champs suivant une direction parfaitement rectiligne.

Les vecteurs $E_1$, $E_2$ et $E_3$ représentant ces polarisations dans des plans $P_1$, $P_2$, $P_3$ perpendiculaires à la direction du faisceau lumineux et situés après la sortie des couches et de la lame demi-onde sont représentés en figure 2, avec leurs angles $\theta$ par rapport à la direction de $E_0$.

Après la deuxième couche 13, le faisceau lumineux traverse un analyseur 14 croisé par rapport à la polarisation incidente $E_0$.

En sortant de cet analyseur, il excite un photodétecteur 15 avec une puissance optique P donnée par la relation :

$$P = P_0 \sin^2 (\theta_2 - \theta_1) \exp (-2La)$$

dans laquelle $P_0$ est la puissance incidente fournie par le laser et a l'absorption des différents milieux traversés.

En sortie de ce photodétecteur, on obtient donc un signal dont l'intensité $i_d$ est proportionnelle à :

$$\sin^2(\theta_2 - \theta_1) \simeq (\theta_2 - \theta_1)^2 = K(h_2 - h_1)^2$$

c'est-à-dire proportionnelle au carré de la composante du gradient du champ selon la direction de propagation.

Dans la réalisation préférée représentée en figure 3, on a omis les aimants permanents qui produisent le champ de saturation $H_S$, pour rendre le dessin plus lisible.

Dans cette réalisation le laser 10 est un laser à semiconducteur du type à jonction polarisée connu sous le nom de « diode laser ». Les dimensions de la surface émissive d'un tel laser sont très faibles, ce qui permet d'envoyer le faisceau lumineux directement dans la première couche 11 en plaçant cette surface émissive contre la tranche de cette couche dont l'épaisseur, environ 30 microns, correspond à une couche dite épaisse.

Outre l'avantage d'un encombrement faible, les diodes laser présentent celui de consommer peu d'énergie. Elles ne nécessitent par exemple qu'un courant de seuil de 5 mA.

Dans une variante de réalisation, on pourra amener la lumière émise par la diode laser jusqu'à la première couche à l'aide d'un fibre optique monomode. Celle-ci permet de filtrer la plus grande partie de l'émission spontanée du laser, qui est mal polarisée, au profit essentiellement de l'émission stimulée, qui est bien polarisée et dont la fibre garde la polarisation.

Les deux couches magnéto-optiques 11 et 13 sont ici formées simultanément sur le support 16 par un procédé qui minimise les erreurs d'alignement et permet d'obtenir une dispersion des caractéristiques magnéto-optiques très faible entre ces deux couches, ce qui représente un avantage important.

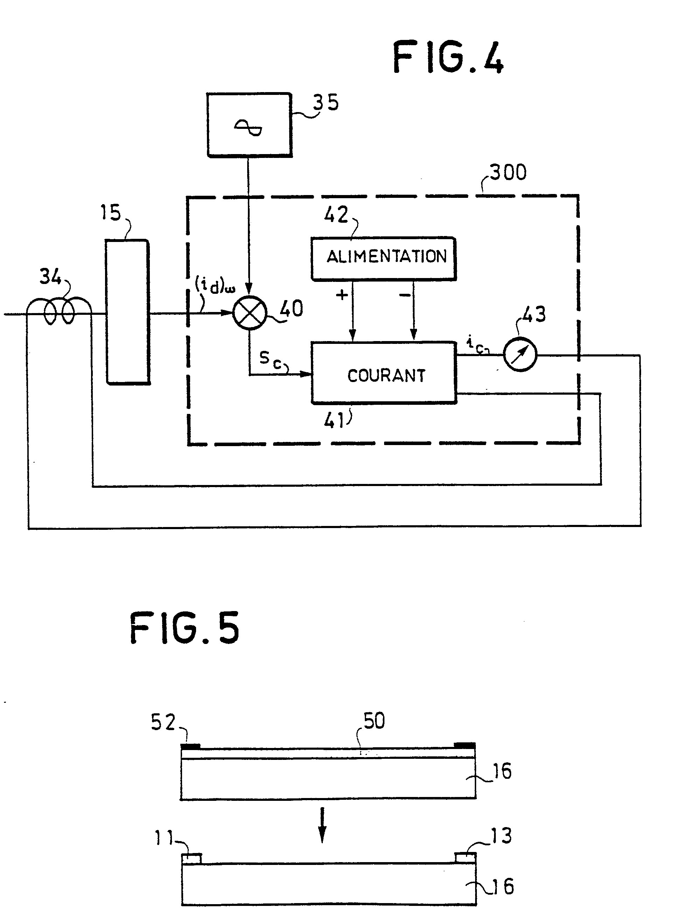

Ce procédé, illustré sur la figure 5, consiste à isoler deux « îlots » d'une même couche cristalline 50 épitaxiée sur un substrat qui forme le support 16. Par usinage ionique sous vide chimiquement actif, la couche épitaxiée est supprimée sauf aux deux extrémités du substrat masquées par un dépôt métallique 52, par exemple d'aluminium gravé par photolithographie. Cette technique permet de conserver la qualité du plan de référence des deux couches constitué par le plan du substrat, qui peut être meilleur que le dixième de frange optique.

Dans un exemple de réalisation, cette couche est un grenat d'ytrium-fer substitué au gallium et au gadolinium, épitaxiée sur un substrat de grenat de gallium-gadolinium poli pour obtenir une planéité de l'ordre de quelques dizaines d'Angströms. Les deux couches sont distantes de 5 cm et ont une largeur de 2 mm avec une épaisseur de 30 microns.

La lame cristalline 1/2 onde 12 est collée sur le substrat 16 entre les deux couches. Pour obtenir une orientation parfaite, la direction de la polarisation incidente est ajustée une fois la lame montée en orientant convenablement le laser 10 puisque l'effet Faraday n'a pas de direction privilégiée.

Pour améliorer la propagation de la lumière dans l'espace libre entre les couches et la lame 1/2 onde, on peut utiliser des microlentilles cylindriques et des diaphragmes pour corriger la divergence du faisceau et éviter les trajets multiples. On a représenté sur la figure 3 une seul lentille 32 et un seul diaphragme 36, placés entre la couche 11 et la lame 12, mais on en utilisera le nombre nécessaire, selon les techniques connues dans l'art, en fonction de la distance entre les couches et la lame.

La divergence du faisceau lumineux en sortie de lame 13 est suffisamment faible pour permettre d'éloigner le photodétecteur 15, une photodiode par exemple, de cette lame de manière à interposer le polariseur 14 et la bobine 34 décrite ci-dessous.

Le photodétecteur 15 délivre un courant $i_d$ qui permet de mesurer le gradient du champ entre les couches 11 et 13. Pour améliorer la précision de la mesure du gradient, on utilise une méthode de mesure dont le principe est connu et déjà appliqué aux magnétomètres. Ce principe consite à moduler l'intensité $i_d$ en superposant un champ magnétique alternatif $h_e \sin \omega t$, appelé champ d'excitation, parallèlement à la direction de propagation du faisceau lumineux. En l'absence de champ continu suivant la direction de propagation, l'intensité $i_d$ a une réponse spectrale ne contenant que des harmoniques paires. En présence d'un champ continu ou lentement variable par rapport à la fréquence du champ alternatif, il apparaît des harmoniques impaires dans la réponse spectrale de $i_d$ et en particulier le fondamental de pulsation $\omega$.

Dans ce but le gradientmètre de la figure 3 comporte deux bobines 30 et 31 dont les axes coïncident avec la direction de propagation du faisceau lumineux. Ces bobines sont reliées à un générateur de courant alternatif 35. Les expressions des rotations de Faraday dans les deux couches sont :

$$\theta_1 = K(h_1 + h_e \sin \omega t) \text{ et } \theta_2 = K(h_2 + h_e \sin (\omega t + \varphi))$$

où $\varphi$ est la différence de phase. Pour maximiser la différence $\theta_2 - \theta_1$ les bobines sont montées et alimentées en opposition de phase ($\varphi \simeq \pi$), les deux couches 11 et 13 étant alors excitées en opposition de phase.

L'intensité $i_d$ en sortie est proportionnelle à $\sin^2 (\theta_1 - \theta_2)$. En remarquant que $\sin^2 (\theta_1 - \theta_2)$ est égal à $1/2 (1 - \cos 2 (\theta - \theta_2))$, et en développant en série de Fourier, le fondamental de pulsation $\omega$ est donné par :

$$(i_d)_\omega = |E_0|^2 \sin K(h_1 - h_2)2J_1 (4Kh_e) \sin \omega t e^{-2La}$$

$J_1$ étant la fonction de Bessel de première espèce d'ordre 1.

Suivant une variante de réalisation on peut utiliser une seule bobine d'excitation, soit au niveau de la couche 11, soit au niveau de la couche 13, mais ceci diminue la sensibilité.

Le signal $i_d$ est alors appliqué à un filtre passe-bande 33 centré sur $\omega$. Ce filtre délivre un signal $(i_d)_\omega$ qui, compte tenu que $K(h_1 - h_2)$ est petit, est proportionnel à $h_1 - h_2$, c'est-à-dire au gradient que l'on veut mesurer.

On remarque que l'analyseur croisé 14 permet d'éliminer optiquement une grande partie de la composante continue et donc de faire travailler le photodétecteur 15 dans de meilleures conditions du point de vue bruit. Dans un gradientmètre moins performant, cet analyseur pourrait être supprimé.

Afin d'optimiser la sensibilité du dispositif, on peut maximiser l'amplitude du fondamental en rendant $J_1(4Kh_e)$ maximum par ajustement de la valeur de $h_e$. Ceci s'obtient en faisant

$$4Kh_e \simeq 1,84, \text{ ce qui donne } h_e = 1,84 \ H_s/4\theta_0 L$$

Pour mesurer le gradient avec la meilleure précision, on utilise une méthode de zéro qui consiste à superposer au champ local de l'une des couches un champ complémentaire à l'aide d'une bobine 34 parcourue par un courant continu $i_e$. Ce champ tend à amener le champ résultant dans cette couche à la valeur du champ local de l'autre couche, en annulant donc le gradient. Lorsque le signal $(i_d)_\omega$ s'annule (au bruit près) la valeur du courant continu $i_e$ dans la bobine 34 donne la valeur du gradient.

Le circuit 300 dont le schéma est représenté en figure 4 permet de mettre en œuvre cette méthode de zéro.

Un détecteur synchrone 40 reçoit d'une part le signal $(i_d)_\omega$ et d'autre part le signal issu du générateur 35.

Il fournit un signal de commande $S_c$ à un générateur de courant 41 alimenté par une alimentation stabilisée 42.

Ce générateur fournit le courant $i_c$ à la bobine 34 et ce courant est mesuré par un galvanomètre 43 qui est gradué en valeurs de gradient.

Suivant une variante de réalisation, le courant $i_c$ est injecté au niveau d'une des deux bobines 30 ou 31 et un transformateur ou un condensateur placé entre les deux bobines empêche le courant $i_c$ de parvenir à l'autre bobine.

Dans un gradientmètre moins performant le signal $S_c$, qui est représentatif en module et en signe du gradient à mesurer, est obtenu par détection et intégration du signal $(i_d)_\omega$.

Avec les valeurs citées plus haut pour les couches sensibles, et pour un champ de saturation $H_S = 80$ A/m, un champ modulant $h_e = 40$ A/m et une fréquence de modulation de 10 kHz, on peut mesurer un gradient de 0,2 nT/m.

Un tel gradientmètre de champ magnétique ayant cette sensibilité avec un faible encombrement et une faible consommation est particulièrement apte à être embarqué dans un satellite ou un engin sous-marin pour être utilisé dans un système de surveillance ou de classification.

**Revendications**

1. Dispositif pour mesurer le gradient d'un champ magnétique par effet magnéto-optique, caractérisé en ce qu'il comprend :
— une source (10) délivrant un faisceau lumineux polarisé rectilignement ;
— un premier milieu (11) magnéto-optique plongé dans le champ magnétique, recevant le faisceau lumineux et faisant tourner son plan de polarisation ;
— une lame 1/2 onde (12) ayant un axe neutre parallèle à la polarisation du faisceau émis par la source recevant le faisceau transmis par le premier milieu, et le transmettant en faisant tourner son plan de polarisation pour qu'il soit en sortie de cette lame symétrique de son plan de polarisation en entrée ;
— un deuxième milieu (13) magnéto-optique plongé dans le champ magnétique, recevant le faisceau lumineux transmis par la lame 1/2 onde, faisant tourner son plan de polarisation et délivrant un faisceau lumineux dont l'angle du plan de polarisation par rapport au plan de polarisation du faisceau émis par la source est proportionnel à la composante du gradient du champ magnétique entre les deux milieux selon la direction de propagation du faisceau lumineux ; les deux milieux magnéto-optiques (11, 13) étant deux morceaux de même largeur d'une même couche épaisse monocristalline de matériau ferrimagnétique épitaxiée sur un même substrat cristallin plan (16).

2. Dispositif selon la revendication 1, caractérisé en ce qu'il comprend en outre un polariseur (14) croisé par rapport à la polarisation du faisceau émis par la source et recevant le faisceau lumineux délivré par le deuxième milieu, et un photodétecteur (15) recevant le faisceau lumineux transmis par le polariseur et délivrant un signal de mesure du gradient.

3. Dispositif selon la revendication 2, caractérisé en ce que ces deux morceaux (11, 13) sont obtenus par usinage ionique de la couche épaisse.

4. Dispositif selon l'une quelconque des revendications 1 à 3, caractérisé en ce qu'il comprend des moyens (30, 31, 35) pour appliquer aux deux milieux (11, 13) des champs magnétiques de modulation en opposition de phase, et des moyens (33, 300) pour mesurer le gradient à partir des composantes de fréquence impaire de la modulation générées dans le faisceau lumineux de sortie.

5. Dispositif selon l'une quelconque des revendications 1 à 4, caractérisé en ce qu'il comprend en outre des moyens (34, 300) pour appliquer à l'un des milieux (11, 13) un champ magnétique de contre-réaction pour annuler le gradient et permettre la mesure par une méthode de zéro.

**Claims**

1. Device for measuring the gradient of a magnetic field by magneto-optical effect, characterized in that it comprises :
— a source (10) supplying a rectilinearly polarized light beam ;
— a first magneto-optical medium (11) exposed to a magnetic field, receiving the light beam and causing its polarization plane to be rotated ;

— a half-wave plate (12) having a neutral axis parallel to the polarization of the beam emitted by the source receiving the beam transmitted by the first medium, and transmitting it while rotating its plane of polarization in such a manner that, on the outlet side of this plate, it is symmetrical with respect to its plane of polarization on the inlet side ;

— a second magneto-optical medium (13) exposed to the magnetic field and receiving the light beam transmitted by the half-wave plate while rotating its plane of polarization and supplying a light beam the angle of the polarization plate of which with respect to the plane of polarization of the beam emitted by the source is proportional to the component of the magnetic field gradient between the two media along the direction of propagation of the light beam ; the two magneto-optical media (11, 13) being two sections of same width of the same monocrystalline thick layer of ferrimagnetic material epitaxially formed on the same plane crystalline substrate (16).

2. Device according to claim 1, characterized in that it further comprises a polarizer (14) which is crossed with respect to the polarization of the beam emitted by the source and receives the light beam supplied by the second medium, and a photodetector (15) receiving the light beam transmitted by the polarizer and supplying a gradient measurement signal.

3. Device according to claim 2, characterized in that the two sections (11, 13) are obtained by ion etching of the thick layer.

4. Device according to any of claims 1 to 3, characterized in that it comprises means (30, 31, 35) for applying to the two media (11, 13) magnetic modulation fields of mutually opposite phase and means (33, 300) for measuring the gradient from the odd frequency components of the modulation generated in the light beam on the outlet side.

5. Device according to any of claims 1 to 4, characterized in that it further comprises means (34, 300) for applying to one of the media (11, 13) a magnetic feedback field for eliminating the gradient and permitting a measurement by the zero method.


**Patentansprüche**

1. Vorrichtung zum Messen des Gradienten eines Magnetfeldes durch einen magnetooptischen Effekt, gekennzeichnet durch folgende Bestandteile :

— eine Quelle (10), die einen linear polarisierten Lichtstrahl liefert ;

— ein erstes magnetooptisches Medium (11), das sich im Magnetfeld befindet, den Lichtstrahl erhält und die Drehung seiner Polarisationsebene bewirkt ;

— ein λ/2-Plättchen (12) mit einer zur Polarisation des von der Quelle ausgesandten Strahls parallelen optischen Achse, das den vom ersten Medium übertragenen Strahl erhält und ihn weiter überträgt, wobei es die Drehung seiner Polarisationsebene bewirkt, damit sie beim Austritt aus dem Plättchen symmetrisch zu seiner Polarisationsebene beim Eintritt in das Plättchen ist ;

— ein zweites magnetooptisches Medium (13), das im Magnetfeld liegt, den vom λ/2-Plättchen übertragenen Lichtstrahl erhält, die Drehung seiner Polarisationsebene bewirkt und einen Lichtstrahl liefert, dessen Drehwinkel der Polarisationsebene bezüglich der Polarisationsebene des von der Quelle ausgesandten Strahls proportional zur Komponente des magnetischen Feldgradienten zwischen den beiden Medien in Ausbreitungsrichtung des Lichtstrahls ist ; wobei die beiden magnetooptischen Medien (11, 13) zwei Stücke gleicher Breite derselben dicken, monokristallinen Schicht aus ferromagnetischem Material sind, die auf demselben ebenen kristallinen Substrat (16) epitaktisch aufgebracht ist.

2. Vorrichtung nach Anspruch 1, dadurch gekennzeichnet, daß sie weiterhin einen Polarisator (14), der zur Polarisation des von der Quelle ausgesanten Strahls über Kreuz steht und der den vom zweiten Medium gelieferten Lichtstrahl erhält, un einen Photodetektor (15) enthält, der den vom Polarisator übertragenen Lichtstrahl erhält und ein Gradienten-Meßsignal liefert.

3. Vorrichtung nach Anspruch 2, dadurch gekennzeichnet, daß die beiden Stücke (11, 13) durch ionische Bearbeitung der dicken Schicht erhalten werden.

4. Vorrichtung nach einem der Ansprüche 1 bis 3, dadurch gekennzeichnet, daß sie Einrichtungen (30, 31, 35) zum Anlegen von magnetischen Modulationsfeldern mit entgegengesetzter Phasenlage, an die beiden Medien (11, 13) und Mittel (33, 300) zum Messen des Gradienten auf Grundlage der Bestandteile ungradzahliger Frequenz der Modulation, die im austretenden Lichtstrahl erzeugt werden, enthält.

5. Vorrichtung nach einem der Ansprüche 1 bis 4, dadurch gekennzeichnet, daß sie weiterhin Mittel (34, 300) zum Anlegen eines Gegenkopplungsfeldes an einem der Medien (11, 13) enthält, um den Gradienten zum Verschwinden zu bringen und die Messung durch Nullabgleich zu ermöglichen.

# FIG.1

# FIG.2

# FIG. 3

# FIG.4

# FIG.5